Europäisches Patentamt

European Patent Office

Office européen des brevets

(11) Publication number:

**0 072 216**
**B1**

## (12) EUROPEAN PATENT SPECIFICATION

(45) Date of publication of patent specification: **12.04.89**

(21) Application number: **82304148.8**

(22) Date of filing: **05.08.82**

(51) Int. Cl.⁴: **H 01 L 21/268,** H 01 L 21/28, H 01 L 21/324, H 01 L 21/263

(54) The production of semiconductor devices by methods involving annealing.

(30) Priority: **05.08.81 JP 122657/81**

(43) Date of publication of application:
**16.02.83 Bulletin 83/07**

(45) Publication of the grant of the patent:
**12.04.89 Bulletin 89/15**

(84) Designated Contracting States:
**DE FR GB**

(56) References cited:
**DE-A-2 837 653**
**US-A-4 243 433**
**JOURNAL OF THE ELECTROCHEMICAL SOCIETY, vol. 128, no. 2, February 1981, pages 384-385, Manchester, New Hampshire, US; S. IWAMATSU et al.: "Self-aligned aluminum gate MOSFET's fabricated by laser anneal"**
**JOURNAL OF APPLIED PHYSICS, vol. 50, no. 5, May 1979, pages 3783-3784, American Institute of Physics, New York, US; H. TAMURA et al.: "Laser-annealing behavior of a phosphorus-implanted silicon substrate covered with a SiO2 film"**

(73) Proprietor: **FUJITSU LIMITED**
**1015, Kamikodanaka Nakahara-ku**
**Kawasaki-shi Kanagawa 211 (JP)**

(72) Inventor: **Sasaki, Nobuo**
**1-14-240, Kawara-cho Saiwai-ku**
**Kawasaki-shi Kanagawa 210 (JP)**

(74) Representative: **Fane, Christopher Robin King et al**
**HASELTINE LAKE & CO. Hazlitt House 28 Southampton Buildings Chancery Lane London, WC2A 1AT (GB)**

## Description

The present invention relates to the production of semiconductor devices by methods involving annealing.

Impurity doped regions in a semiconductor substrate can be formed by using a "self-alignment" method wherein an aluminum gate electrode is used as a mask. Such self alignment methods can be applied to the formation of source and drain regions of field effect transistors (FET) in semiconductor substrates. Since no space is necessary for position alignment of photo masking material in a self-alignment method, self-alignment can be an effective technique to increase the degree of semiconductor device integration. In one such method, however, after gate electrodes are formed on gate insulating layers, heat treatment is carried out at 500°C to activate the source and drain regions using the gate electrodes as masking material. Therefore, in such a self-alignment method, it is necessary that the material of the gate electrodes have high heat resistance. For example, polycrystalline silicon, which has high heat resistance, can be used for the gate electrodes. Even considerable doping of impurities into the polycrystalline, however, fails to reduce the electrical resistance of the doped polycrystalline to the level of aluminum. Thus, the switching speed of such a semiconductor device is lowered, as compared to one having aluminum gate electrodes.

It is now possible for laser annealing of semiconductors to be employed to activate the source and drain regions. While aluminum has poor heat resistance, it reflects a laser beam well. Therefore, it should be possible to use aluminum for the masking material to form the source and drain regions by the ion-implanting or doping method, then anneal the regions by laser irradiation so as to produce FET's having aluminum gate electrodes by a self-alignment process. As a result, the integration density and switching speed of semiconductor devices can be improved. Japanese Unexamined Patent Publication No. 55—102271 describes the use of aluminum as gate electrodes and annealing an ion-doped layer by laser beam irradiation using the aluminum gate electrodes as masking material. However, in the process described in Japanese Unexamined Patent Publication No. 55—102271, the laser beam irradiation has a detrimental effect on the aluminum gate electrodes. Namely, the effect of irradiation energy of the laser beam on the aluminum is so strong that it damages the aluminum despite much of it being reflected by the aluminum. Irradiation of 2.2 joules of energy by a ruby laser beam, for example, can fuse and further disperse the aluminum of gate electrodes. Irradiation of even 0.31 joules of energy by a laser beam can produce a crack network at the surface of the aluminum gate electrodes. Such irradiation energy can thus damage the aluminum gate electrodes themselves.

On the other hand, while irradiation of a low amount of energy by a laser beam, for example 0.146 joules, will not damage the aluminum, it will also not activate the impurity doped regions enough to lower the sheet (surface) resistivity. Thus, a region into which arsenic ions ($As^+$) were doped under conditions of $5+10^{15}$ cm$^{-2}$ dose and 100 KeV energy can be reduced only to a sheet resistivity of 100 $\Omega/\square$ by an irradiation energy of 0.146 joule compared with a sheet resistivity of 50 $\Omega/\square$ by an irradiation energy of 0.3 joule.

As explained above, a high irradiation energy of a laser beam on aluminum gate electrodes can damage the aluminum, and a low irradiation energy of a laser beam on aluminum gate electrodes may not be sufficient to activate the impurity doped region to lower the sheet resistivity.

It is desirable to provide a method for producing a semiconductor device having an aluminum gate electrode in which a low sheet resistivity can be obtained by means of laser beam annealing at the ion doped region without damage to the aluminum electrode, whereby high integration density and high switching speed can be obtained.

It has been proposed in DE—A—2 837 653 to form a thin dielectric masking layer, in particular of $SiO_2$, over an area to be irradiated with a laser beam, this masking layer extending both over an aluminum gate electrode and over implanted self-aligned source-drain regions that are to be activated by the irradiation, and having locally different thicknesses such that it acts as an antireflection layer over the regions to be activated and a reflection layer over the other regions.

According to the present invention a method for producing a semiconductor device comprises the steps of:

forming a $SiO_2$ gate insulating layer on a semiconductor substrate of one conductivity type,

forming an aluminum gate electrode on said gate insulating layer,

forming impurity doped regions in said semiconductor substrate by means of implantation of opposite conductivity type impurity ions into said semiconductor substrate adjacent to said aluminum gate electrode which serves as a mask,

covering the upper surface of said aluminum gate electrode with an insulating layer of aluminum oxide by oxidizing said aluminum gate electrode, using anodic oxidation, and

annealing said impurity doped regions by subjecting them to an irradiating laser beam which also impinges on said aluminum gate electrode;

the thickness of the aluminum oxide insulating covering layer being substantially equal to $\lambda m/2n$;

where n is the index of refraction of the insulating covering layer, $\lambda$ is the laser beam wavelength in a vacuum, and m is a positive integer.

Reference will now be made, by way of example, to the accompanying drawings; in which:

Figs. 1 to 3 are explanatory sectional views illustrating a portion of a semiconductor device being produced by a method embodying the present invention; and

Fig. 4 is a graph illustrating the relation between laser beam absorption ratio and thickness of an insulating layer.

Before the present invention was conceived, various studies were carried out, whereby it was found that the reason for the above-described crack network was that when an aluminum gate electrode was heated by beam irradiation, it expanded. During the process of cooling by heat dispersion from the surface, however, the surface would contract first. In a method embodying the present invention it is found that formation of an insulating layer on an aluminum gate electrode before the laser annealing can allow sufficient annealing of the impurity doped region and the aluminum gate electrode and stop formation of crack network. This is because the insulating layer suppresses heat dispersion from the surface of the aluminum gate electrode and results in an even temperature distribution in the aluminum gate electrode. At the same time, the insulating layer can dynamically inhibit the aluminum gate electrode from cracking.

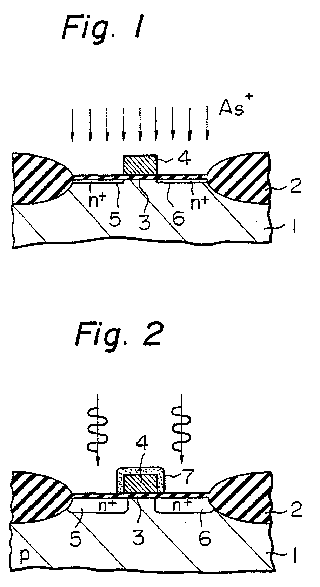

Referring to Fig. 1, for example, a usual technique is used to form, on p type silicon semiconductor substrate 1, silicon dixoide field insulating layer 2, silicon dioxide gate insulating layer 3, and aluminum gate electrode 4.

An ion implantation technique is then used to dope arsenic ions into p type silicon substrate 1 at a $5 \times 10^{15}$ cm$^{-2}$ dose amount and 100 KeV energy so as to form n$^+$ type source region 5 and n$^+$ type drain region 6 in silicon substrate 1.

Referring to Fig. 2, aluminum oxide layer 7 is formed on the surface of the aluminum gate electrode 4 by oxidation by the anodic oxidation process. This oxidation of aluminum may be carried out prior to the ion implanting process. Then, a YAG laser beam having wavelength of 1.06 μm is irradiated on to the inpurity doped regions and the aluminum gate electrode to anneal source region 5 and drain region 6, producing a sheet resistivity of regions 5 and 6 of approximately 50 $\Omega/\square$. By forming an aluminum oxide layer of a suitable thickness, as explained below, in this manner, cracking in the aluminum gate electrode 4 can be avoided.

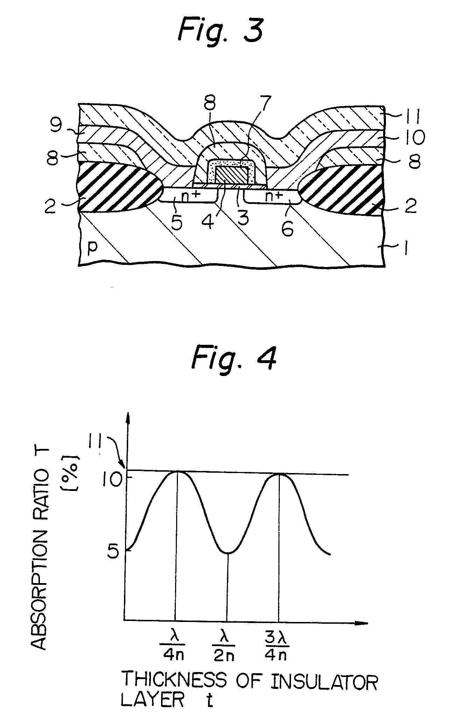

Referring to Fig. 3, a well known technique is used to form phosphosilicate glass layer 8 on the device shown in Fig. 2. An electrode contact hole is formed by patterning phosphosilicate glass layer 8 and silicon dioxide gate insulating layer 3. As aluminum layer is formed in the electrode contact hole and on phosphosilicate glass layer 8. Source electrode 9 and drain electrode 10 are formed by patterning the aluminum layer. Phosphosilicate glass layer 11 is formed on source electrode 9, phosphosilicate glass layer 8, and drain electrode 10 and, thus, an integrated circuit (IC) chip is produced. A further contact hole may also be made to provide for electrical connection to the electrode.

The change in the laser beam absorption ratio of the aluminum layer as a function of the thickness of the insulating layer, in the case where an insulating layer is present on the aluminum layer, is shown in Fig. 4. Thus change is due to the interference of light.

As apparent from Fig. 4, it is effective that thickness $t$ of the insulating layer is equal to the value λm/2n; wherein n is the index of refraction of the insulating layer on the aluminum layer, λ is the beam wavelength in a vacuum, and m is a positive integer. The data shown in Fig. 4 was obtained by using a YAG laser having a wavelength of 1.06μm.

Therefore, in the case of a ruby laser beam having a wavelength of 0.694μm, to minimize the absorption ratio when using aluminum oxide, which has an index of refraction of 1.77, the thickness of the aluminum oxide layer should be 1960 Å. In the case of a YAG laser beam having a wavelength of 1.03μm, to minimize the absorption rate when using aluminum oxide, the thickness of the aluminum oxide layer should be 2900 Å. The above thicknesses of the aluminum oxide layers can be calulated from the formula, λm/2n. As can be seen from Fig. 4, a thickness of λ/12n, considerably lower than λ/4n, can also produce a roughly minimum absorption rate T. On the other hand, to activate the source and drain regions under a gate insulating layer, a large absorption ratio is preferable. Therefore, the thickness of the gate insulating layer should be formed to be λ(2m−1)/4n'; wherein n' is the index of refraction of the gate insulating layer, λ is the laser beam wavelength in a vacuum, and M is a positive integer.

In the above examples, a laser beam, in particular a ruby laser beam or YAG laser beam, was used as the beam by which impurity doped regions were annealed.

In an embodiment of the present invention, as explained above, at least the upper surface of the aluminum gate electrode is covered by anodic oxidation with an insulating layer of a thickness selected by the formula λm/2n so that the aluminum gate electrode can withstand the annealing process whereby the source and drain regions are activated, with the result that a low sheet resistivity can be obtained.

An embodiment of the present invention can thus be used for the production of a semiconductor device including an FET produced by the self-alignment method and using an aluminum gate electrode.

While preferred embodiments of the invention have been shown, it will be obvious that modifications may be made within the scope of the disclosure of the specification.

**Claims**

1. A method of producing a semiconductor device comprising the steps of:

forming a SiO$_2$ gate insulating layer (3) on a semiconductor substrate (1) of one conductivity type,

forming an aluminum gate electrode (4) on said gate insulating layer,

forming self-aligned impurity doped regions (5, 6) in said semiconductor substrate (1) by means of implantation of opposite conductivity type impurity ions into said semiconductor substrate adjacent to said aluminum gate electrode, which serves as a mask,

forming a dielectric layer (7) covering the surface of said aluminum gate electrode, and

annealing said impurity doped regions (5, 6) by subjecting them to an irradiating laser beam which also impinges on said aluminum gate electrode (4);

characterised in that said dielectric layer (7) is an insulating layer of aluminum oxide formed over the upper surface of said aluminum gate electrode by anodic oxidation of said aluminum gate electrode, and in that the thickness of said aluminum oxide insulating covering layer is substantially equal to $\lambda m/2n$; where n is the index of refaction of the insulating covering layer, $\lambda$ is the laser beam wavelength in a vacuum, and m is a positive integer.

2. A method as claimed in claim 1 wherein the said impurity doped regions underlie the said $SiO_2$ gate insulating layer and the thickness of said $SiO_2$ gate insulating layer (3) is substantially equal to $\lambda(2M-1)/4n'$, where n' is the index of refraction of said gate insulating layer (3), $\lambda$ is the laser beam wavelength in a vacuum and M is a positive integer.

## Patentansprüche

1. Verfahren zur Herstellung einer Halbleitervorrichtung mit den folgenden Schritten:

Bilden einer $SiO_2$-Gateisolierschicht (3) auf einem Halbleitersubstrat (1) von einem Leitfähigkeitstyp,

Bildung einer Aluminiumgateelektrode (4) auf der gennannten Gateisolierschicht,

Bilden selbstausgerichteter mit Verunreinigungen dotierter Bereiche (5, 6) in dem genannten Halbleitersubstrat (1), mittels Implantation von Verunreingungsionen vom entgegengesetzten Leitfähigkeitstyp in das genannte Halbleitersubstrat neben der genannten Aluminiumgateelektrode, die als eine Maske wirkt,

Bilden einer dielektrischen Schicht (7), die die Oberfläche der genannten Aluminiumgateelektrode bedeckt und

Annealbehandlung der genannten mit Verunreinigungen dotierten Bereiche (5, 6), indem diese einem einfallenden Laserstrahl unterworfen werden, welcher auch auf die genannte Aluminiumgateelektrode (4) auftrifft;

dadurch gekennzeichnet, daß die dielektrische Schicht (7) eine isolierende Schicht aus Aluminiumoxid ist, die über der oberen Oberfläche der genannten Aluminiumgateelektrode durch anodische Oxidation der genannten Aluminiumgateelektrode gebildet wurde, und daß die Dicke der genannten isolierenden Deckschicht aus Aluminiumoxid im wesentlichen gleich $\lambda m/2n$ ist; wobei m der Brechungsindex der isolierenden Deckschicht, $\lambda$ die Wellenlänge des Laserstrahls in Vakuum und m eine positive ganze Zahl ist.

2. Verfahren nach Anspruch 1, bei dem die genannten mit Verunreinigungen dotierten Bereiche unter der genannten $SiO_2$-Gateisolierschicht liegen und die Dicke der genannten $SiO_2$-Gateisolierschicht (3) im wesentlichen gleich $\lambda(2M-1)/4n'$ ist, wobei n' der Brechungsindex der genannten Gateisolierschicht (3), $\lambda$ die Wellenlänge des Laserstrahls in Vakuum und M eine positive ganze Zahl ist.

## Revendications

1. Procédé de production d'un dispositif à semiconducteurs comprenant les opérations suivantes:

former une couche d'isolation de grille (3) en $SiO_2$ sur un substrat semiconducteur (1) d'un premier type de conductivité,

former une électrode de grille (4) en aluminium sur ladite couche d'isolation de grille,

former des régions, dopées par des impuretés, autoalignées (5, 6) dans ledit substrat semiconducteur (1) au moyen d'une implantation d'ions d'impuretés du type opposée de conductivité dans ledit substrat semiconducteur au voisinage de ladite électrode de grille en aluminium, qui fait fonction de masque,

former une couche diélectrique (7) recouvrant la surface de ladite électrode de grille en aluminium, et

recuire lesdites régions dopées par des impurétés (5, 6) en les soumettant à une irradiation par un faisceau laser qui frappe également ladite électrode de grille (4) en aluminium;

caractérisé en ce que ladite couche diélectrique (7) est une couche isolanteen oxyde d'aluminium formée par-dessus la surface supérieure de ladite électrode de grille en aluminium par oxydation anodique de ladite électrode de grille en aluminium, et en ce que l'épaisseur de ladite couche de revêtement isolante en oxyde d'aluminium est sensiblement égale à $\lambda m/2n$, où n est l'indice de réfraction de la couche de revêtement isolante, $\lambda$ est la longueur d'onde du faisceau laser dans le vide, et m est un entier positif.

2. Procédé selon la revendication 1, où lesdites régions dopées par des impuretés se trouvent au-dessous de la couche isolante de grille en $SiO_2$ et l'épaisseur de ladite couche isolante de grille (3) en $SiO_2$ est sensiblement égale à $\lambda(2M-1)/4n'$, où n' est l'indice de réfraction de ladite couche isolante de grille (3), $\lambda$ est la longueur d'onde du faisceau laser dans le vide, et M est un entier positif.

## Fig. 1

## Fig. 2

## Fig. 3

## Fig. 4

ABSORPTION RATIO T [%]

$\frac{\lambda}{4n}$  $\frac{\lambda}{2n}$  $\frac{3\lambda}{4n}$

THICKNESS OF INSULATOR LAYER  t

2